# EUROPEAN PATENT APPLICATION

(11) **EP 1 058 297 A2**
(43) Date of publication of application: **06.12.2000**
(21) Application number: 00304681.0
(22) Date of filing: 01.06.2000
(51) Int. Cl.: H01L 21/00

(54) **Brush core for disk scrubbing apparatus and method**

(30) Priority: 01.06.1999 US 136912 P
(71) Applicant: Applied Materials, Inc., Santa Clara, California 95054 (US)
(72) Inventor: BROWN, Brian J., Palo Alto CA 94301 (US); YU, Ying, Cupertino CA 95014 (US); ANDEEN, David, Los Gatos CA 95032 (US)
(74) Representative: Bayliss, Geoffrey Cyril

(57) **Abstract**

A compressible brush core having a first mechanism for allowing compression of the outer diameter of the brush core and a second mechanism for prohibiting compression of the outer diameter of the core. The multiple-part brush core comprises an outer core component (30), having a hollow center and having at least one notch (31) for allowing compression of the core during insertion into the hollow center of a brush, and an inner core component (40) for insertion into the center of the outer core component to provide rigidity during use. The brush core assembly may additionally include mounting mechanisms (51) including a spring-mounted spindle (61, 62) for engaging a mounting socket on a scrubbing device. Alternatively, the scrubbing device may include a spring-mounted spindle (71, 72) for engaging the mounting socket (i.e., hollow center) of the brush core assembly. During mounting of the brush core assembly into a scrubbing device, the spring-mounted spindle retracts under a compressive force. When the compressive force is released, the spindle is released to engage the mounting socket, and the spring holds the brush core assembly in place.

## Description

The present invention relates generally to apparatuses for cleaning thin discs, such as semiconductor wafers, compact disks, and the like. More particularly, the invention relates to brush apparatuses for cleaning thin discs.

For fabrication of semiconductor devices, thin slices or wafers of semiconductor material require polishing by a process that applies an abrasive slurry to the wafer's surfaces. After polishing, slurry residue is generally cleaned or scrubbed from the wafer surfaces via mechanical scrubbing devices, such as polyvinyl acetate (PVA) brushes, brushes made from other porous or sponge-like material, or brushes made with nylon bristles.

A brush apparatus for cleaning discs is covered by the co-pending U. S. patent application Serial No. 09/113,447, having a filing date of July 10, 1998 and assigned to the present assignee, entitled "Wafer Edge Scrubber", the teachings of which are incorporated by reference herein. The invention described in the application provides an improved scrubbing apparatus having a profiled surface to more effectively mechanically remove residue from the wafer's profiled surface (i.e., the flat surface and the beveled edge).

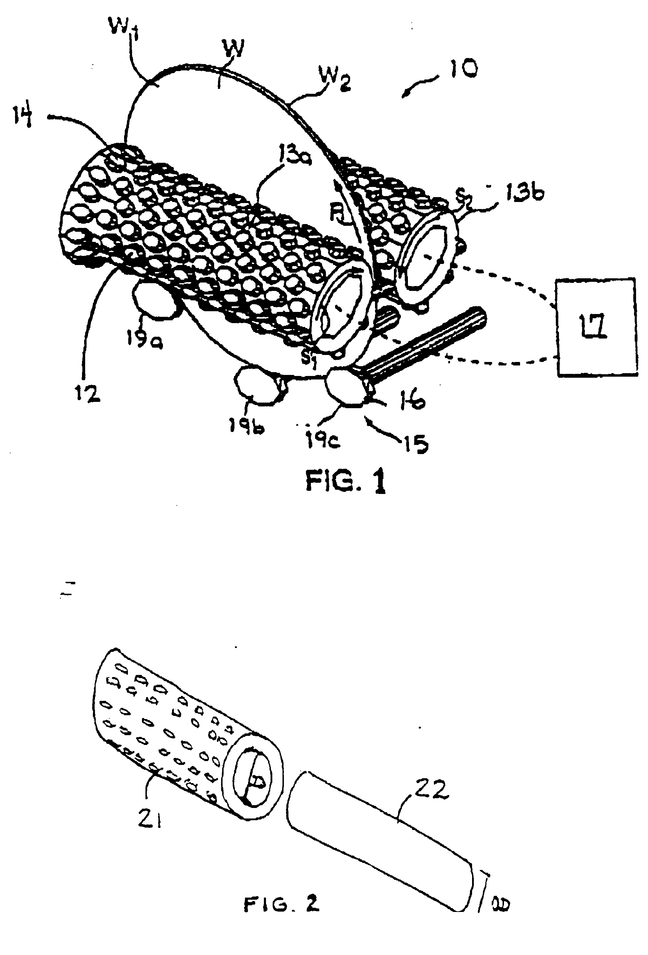

Figure 1 is a side perspective view of a scrubbing device 10 for wafer cleaning including a platform 15 for supporting a wafer w to be cleaned. First and second brush rollers, 13a and 13b, are coupled to the platform 15 so as to contact both sides of a wafer positioned thereon. A conventional mechanism 17, such as a motor, is operatively coupled to the first and second brush rollers, 13a and 13b, so as to selectively rotate the first and second brush rollers, 13a and 13b. Further, a rotating mechanism 17 is operatively coupled to the platform 15 so as to rotate the wafer w positioned thereon. Preferably, as shown in FIG. 1, the platform 15 comprises a plurality of rotating wheels 19a-c for both supporting and rotating the wafer w. Specifically, each rotating wheel 19a-c has a central notch or groove 16 having a sidewall angle (e.g. of 45E) such that only the very edge of the wafer w contacts the rotating wheels 19a-c. The notches 16 thus prevent damage to the front or back wafer surfaces.

In operation, the first and second brush rollers, 13a and 13b, are initially in an open position, a sufficient distance from each other so as to allow a wafer to be inserted therebetween. Thereafter, the wafer w to be cleaned is positioned between the first and second brush rollers, 13a and 13b, and the brush rollers assume a closed position, sufficiently close to each other so as to both hold the wafer w in place therebetween and to exert a force on the wafer surfaces adequate to achieve effective cleaning.

Once the brush rollers are in the closed position, the spinning mechanism 17 is engaged and the first and second brush rollers, 13a and 13b, begin to spin. Preferably the brush rollers spin in opposite directions, as indicated by arrows S1 and S2 in FIG. 1, applying forces to the wafer in a first direction (e.g., downward) while the wafer rotates, so as to drive the wafer into the rotating wheels 19a-c so that the wafer remains engaged thereby.

The top and bottom surfaces of wafer w are cleaned of slurry residue when contacted by the nodules, indicated by 12 and 14, of the brush rollers. More specifically, a first set of nodules 12 contacts the flat surfaces of the wafer and the second set of nodules 14 contact the edge surfaces of the wafer. In addition, water is supplied to the wafer surface i through perforations in the brush surface to assist in the removal of contaminants.

While the pair of brush rollers spin, the rotating wheels 19a-c which engage the wafer's edge rotate causing the wafer to rotate. Rotation of the wafer w ensures that the pair of brush rollers, 13a and 13b, contact each point along the surface of the wafer w. Preferably, the profile of the scrubbing surface of a brush roller is designed to follow the wafer's profile, such that a uniform contact force is applied to both the flat surfaces and the profiled surfaces of the wafer.

The brush rollers are, as illustrated in FIG. 2, typically comprised of a soft cylindrical outer brush, 21, of Polyvinyl Acetate (PVA) having a hollow center, mounted on a rigid core, 22, made of polypropylene or polyvinylidenefluoride, which is inserted into the hollow center of the brush to provide structural rigidity. It is the core of the brush roller assembly that is operatively coupled to the rotating mechanism, 17, for rotating the brush roller assembly. The core is sized such that its outer diameter (OD) fits snugly against the inner diameter (ID) of the brush. When the brush roller assembly is caused to rotate by the rotating mechanism, a snug fit is required between the core and the brush so that the brush and core rotate together with no relative rotation caused by slipping therebetween. The rigid core preferably has a conduit disposed along its center axis for providing fluid (i.e., water) to the wafer surface during cleaning.

The nodules or bristles on the brushes become worn, due to repeated usage, and must be replaced periodically. During replacement, the core 22 is removed from the worn brush and inserted into the hollow core of a new brush. Necessarily, there are costs associated with the replacement process, including operator time and machine downtime. In addition to the time required for detaching the old brush roller assembly from the rotating mechanism and reattaching the new assembly, the step of physically loading the new brush onto the core is time consuming due to the tight tolerances required for the snug fit. In addition, the relatively soft brushes are often torn in the loading process, resulting in further downtime and increased costs. Moreover, the insertion of the core into the new brush requires considerable handling of the brush, which can transfer oils and other contaminants to the brush, thereby compromising the integrity of the brush assembly for future wafer cleaning.

Accordingly, an improved method for mounting brush and core assemblies for wafer cleaning, and an improved apparatus for facilitating the mounting of brushes on cores for wafer cleaning is needed.

One aspect of the invention comprises a compressible brush core having a mechanism for allowing compression of the outer diameter of the brush core and a mechanism for selectively prohibiting compression of the outer diameter of the core. The inventive multiple-part brush core may comprise an outer sleeve core component, having a hollow center and having at least one notch for allowing compression of the core during insertion into the hollow center of a brush, and an inner mandarin core component for insertion into the center of the outer core component to provide rigidity during use. The at least one notch in the outer core may comprise one or more slits extending along all or a portion of the length of the outer core. In addition, the first, notched, end of the outer core component may be tapered to facilitate insertion into the hollow center of the brush, and may include a plurality of rows of threads for securing with an oppositely-threaded securing device (e.g. a nut, optionally having mounting hardware disposed thereon) upon final assembly. The second end of the outer core component may include a section of expanded diameter, providing a stopping point for the brush disposed thereon. The second end may additionally comprise a plurality of rows of threads disposed along its inside diameter for fixedly attaching to the inner core component. Alternatively, the second end of the outer core may include a slit for engaging a compressible pin, located on the inner core component, for securing the two components of the core.

The inner core component may comprise a rigid component having a first end for insertion into the second end of the outer core and a second end, may include a plurality of rows of threads for fixedly connecting to the threads located on the inside of the second end of the outer core, or a retractable pin for engaging a slit in the surface of the outer core component. The second end of the inner core may additionally include mounting hardware, including a spring-loaded spindle, for attaching to the scrubbing device and rotating mechanism thereof. The inner core component may include a conduit disposed along its axis for supplying deionized water, or other fluid as appropriate, to the wafer surface.

Spring-loaded mounting hardware, disposed on the second end of the inner core or on the securing device attached at the first end of the outer core component, may be provided for coupling to a scrubber device. Alternatively, the scrubbing device may include a pair of opposed spindles adapted to support the brush and core assembly, with one of the spindles being mounted on a compressive spring. For installing a brush and core assembly into a scrubber device, the spring-loaded coupling disposed either on either the brush core assembly or on the scrubber device is compressed, aligned with an opposite coupling, and released, thereby achieving coupling whereby the force of the spring will hold the brush core assembly in place.

Other features and advantages of the present invention will become more fully apparent from the following detailed description of the preferred embodiments, with reference to the accompanying drawings in which:
FIG. 1 is a side perspective view of a scrubbing device for wafer cleaning as previously described;
FIG. 2 is a side perspective view of a brush roller assembly in accordance with the prior art as previously described;
FIG. 3 is a side perspective view of an outer portion of the inventive two part brush core;
FIG. 4 is a side perspective view of the inner portion of the inventive two part brush core;
FIG. 5 is a side perspective view of an inventive two part core comprising the inner and outer portions of FIGS. 3 and 4;
FIG. 6 is a side perspective view of a brush core assembly being inserted into a scrubber device having an inventive spring-loaded coupling; and
FIG. 7 is a side perspective view of a brush core assembly having spring-loaded mounting hardware incorporated into one of the core components.

The brush core of the present invention includes first and second components including a hollow outer core component, to be inserted into the hollow center of a brush, and an inner core component for insertion into the hollow center of the outer core component, wherein the outer diameter of the outer core, in an uncompressed state, is sized to fit snugly within the hollow center of the brush, and the outer diameter of the inner core is substantially the same as the inner diameter of the outer core in an uncompressed state. The hollow outer core component is adapted to be selectively compressed (e.g., manually) to facilitate insertion into the hollow center of the brush. The inner core component is rigid and, when inserted into the hollow outer core component, provides structural integrity to the assembly.

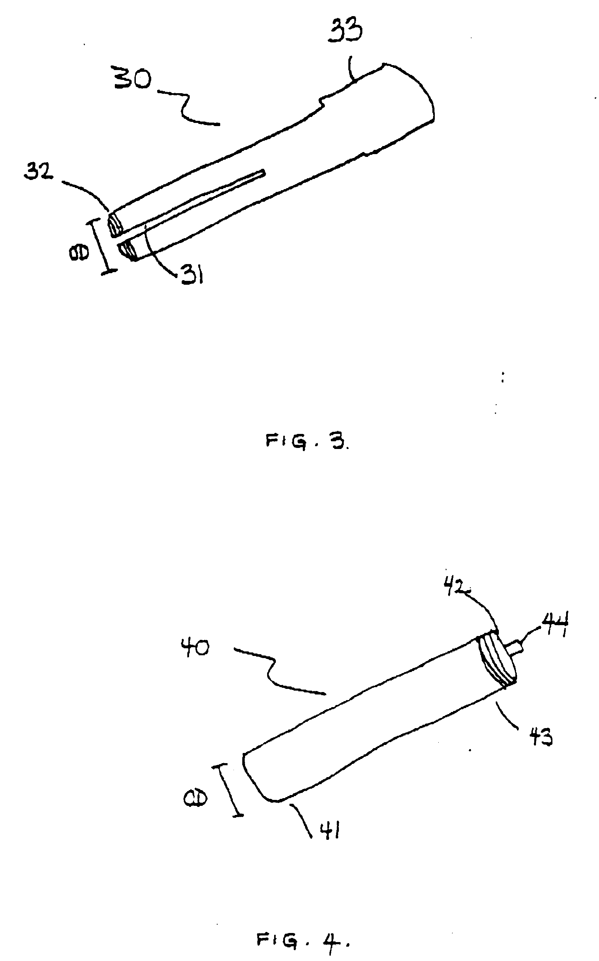

The outer core of the present invention is illustrated in FIG. 3. As depicted in FIG. 3, the outer core, 30, is a hollow cylinder of substantially fixed outer diameter (OD) having a first and a second end and including at least one notch, 31, disposed at the first end. Polyvinylidenefluoride (PVDF) is the material of choice for fabricating the outer core component, although other materials, such as polypropylene or Teflon™ may be used. The outer diameter of the outer core 30 in its uncompressed state is substantially the same as the inner diameter of the brushes with which the core assembly will be used. The outer core 30 has a wall thickness and inner diameter which are chosen to be optimal for both compressibility and structural integrity for the selected materials. Unduly thick walls may compromise the compressibility of the structure, while unduly thin walls may wear too quickly, particularly at the base of a slit or notch where the forces from compression will be concentrated.

Compression in the outer core 30 is realized by exerting pressure onto the notch 31 at the first end of the outer core, which effectively reduces the outer diameter (OD) of the outer core and allows the brush (FIG. 1) to easily slide onto the outer core. The notch 31 additionally provides a path for release of fluid (e.g., deionized water) to the brush during scrubbing. The width of each notch 31 is selected to allow compression to achieve reduced diameter while optimizing fluid flow to the brush surface. The length of the notch 31, or slit, may be arbitrarily selected, with an optimal length being substantially the length of the outer core 30, to effectively reduce the diameter of the entire outer core 30 during brush mounting and to optimize fluid flow. In addition, there may be any number of slits 31 cut into the first end of the outer core 30. An optimal arrangement is to provide four (4) slits disposed at 90° angles with respect to each other. Such an array of slits allows uniform compression of at least the first end of the outer core 30 without disproportionately stressing the remainder of the outer core material.

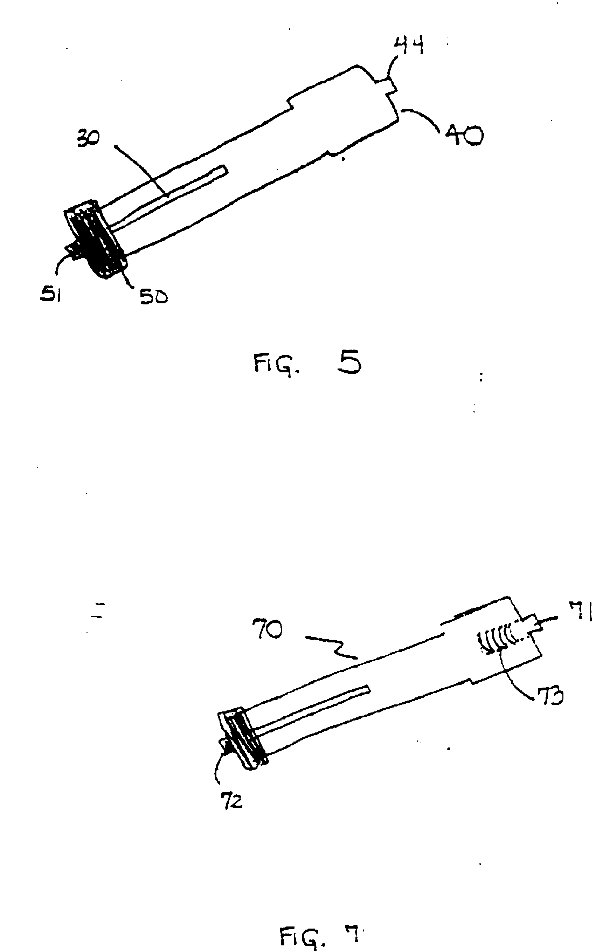

The first, notched, end of the outer core 30 is preferably tapered for ease of insertion into the hollow center of the brush (FIG. 1). Once the tapered end has been inserted, compression can be realized by exerting pressure at the second end of the outer core 30 to further insert the outer core 30 into the brush center. In this way, it becomes unnecessary for a handler to actually touch the first outer core end in order to effect compression, thereby minimizing potential contamination of the assembly. The tapered end may additionally be provided with a plurality of rows of threads 32, for securing with an oppositely-threaded securing device (e.g. a nut - not shown) upon final assembly, as further detailed below with reference to FIG. 5.

The second end of the outer core component 30 preferably includes a section of expanded diameter 33, for providing a stopping point for the brush (FIG. 1) disposed thereon. The second end of the outer core 30 preferably additionally comprises a mechanism for fixedly engaging the inner core 40 to prevent rotational movement between the inner and outer core components 30, 40. The engaging mechanism may comprise a plurality of rows of threads (not shown) disposed along the outer core 30's inside diameter for fixedly attaching to the inner core (FIG. 4). Alternatively, the engaging mechanism may comprise a slot (not shown) disposed in the surface of the outer core component 30 for engaging a retractable locking pin (not shown) disposed on the surface of the inner core component (FIG. 4).

The inner core component, illustrated at 40 in FIG. 4, comprises a rigid component of fixed diameter having a first end, 41, for insertion into the second end of the outer core and a second end 42, preferably including a mechanism for fixedly connecting to the outer core component 30. The mechanism for fixedly connecting to the outer core component 30 may comprises a plurality of rows of threads 43, for fixedly connecting to the threads located on the inside of the second end of the outer core 30, or a retractable locking pin (not shown) for engaging a slot (not shown) in the surface of the outer core component. The second end 42 of the inner core 40 preferably additionally includes mounting hardware 44, for attaching to the scrubbing device and rotating mechanism (FIG. 1). The inner core 40 is preferably made of polyvinylidenefluoride, although it too may be fabricated of alternative materials such as polypropylene or Teflon. The outer diameter, OD, of the inner core 40 is constant along its length and is substantially the same as the inner diameter of the outer core 30 when the outer core 30 is in an uncompressed state. The inner core 40 may be solid, but is preferably fabricated with a conduit (not shown) disposed along its center axis for supplying water, or other fluid as appropriate, to the brush surface. The conduit (not shown) preferably extends substantially the length of the inner core 40. The conduit may be formed by drilling the polyvinylidenefluoride, or other inner core material, the diameter of the conduit being limited so that the wall thickness of the inner core 40 remains sufficient to maintain the necessary rigidity to prevent the outer core 30 from being compressed during the wafer cleaning process.

The core assembly, as illustrated in FIG. 5, comprises the outer core 30 having the inner core 40 disposed therein. Securing mechanism 50, shown as a threaded nut, engages the plurality of rows of threads 32 located at the first end of the outer core component 30, and effectively locks the outer and inner cores together. The securing means 50 may additionally include hardware 51, for mounting the brush assembly into the scrubbing device (FIG. 1).

In operation, the entire brush assembly would be i mounted into the scrubber device, as depicted in FIG 1. When the brush, becomes worn, the brush assembly is disengaged from the scrubber device. Securing means 50 is first removed and the inner core 40 is unscrewed from its secured location within the hollow of the outer core 30. Once the inner core 40 has been removed, the old brush is readily removed from the outer core 30 which may compress somewhat during removal of the brush. A new brush can then be mounted on the outer core 30 by inserting the tapered first outer core end into the hollow center of the brush (FIG. 1). As noted above, the tapered first outer core end will compress on contact, thereby allowing the entire outer core to be readily inserted into the hollow center of the brush with minimal operator handling. Alternatively, and in the case where the outer core 30 is not tapered, an operator can physically compress the outer core 30 by pressing the walls in toward the notches 31. The latter method will, however, increase the risk of depositing oils or other contaminants onto the brush assembly.

Once the brush has been mounted onto the outer core 30, with one end of the brush contacting the portion 33 of the second end of the outer core at which the diameter increases, the inner core 40 is inserted into the hollow center of the outer core 30. Once the inner core 40 has been inserted, and secured to the outer core 30, securing mechanism 50 is threaded onto the first end of the outer core 30. The brush assembly may then be remounted in the scrubbing device as detailed below.

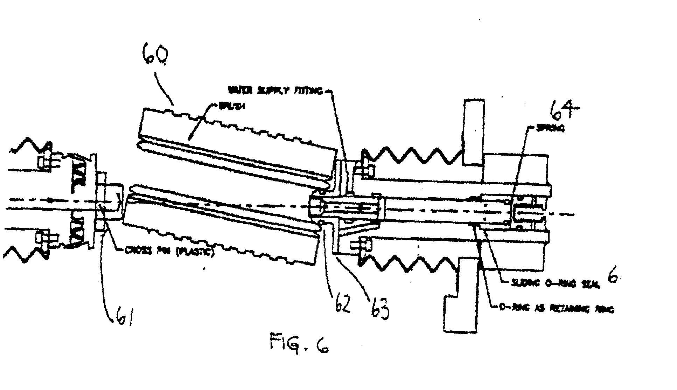

FIG. 6 illustrates the brush core assembly 60 mounted onto spindles 61 and 62 of the scrubbing device. In accordance with one aspect of the present invention, one of the spindles of the scrubbing device is spring loaded, such that the spindle will retract, when a force compresses the spring, and will engage the brush core assembly 60 when the compressing force is removed. As illustrated, spindle 62 is coupled via push plate 63 to spring 64. An O-ring seal 65 may be disposed about spring 64 to prevent fluid from leaking during use. Engagement of spindle 62 by the brush core assembly 60 is followed by exertion of a force against push plate 63, causing spring 64 to compress. Once the brush core assembly 60 is brought into alignment with and engages spindle 61, the compressing force on spring 64 is released. Thereafter, the tension in spring 64 holds spindle 62 in place to secure the brush core assembly 60.

FIG. 7 provides an alternative brush core assembly 70 wherein spring-loaded mounting hardware is disposed on one of the brush core components. Spindles 71 and 72 are provided for insertion into fixed mounting sockets (not shown) in the scrubber device. As illustrated, spindle 71, located at the second end of the inner core component, is engaged by spring 73. Compression of spring 73 will result in the spindle 71 contracting while the brush core assembly 70 is positioned within the scrubber device. Once positioned in alignment with the mounting sockets of the scrubber device, the compressive force on spring 73 is released as spindle 71 engages its mounting socket. Thereafter, the tension in spring 73 holds the brush assembly 70 in place.

The foregoing description discloses only the preferred embodiments of the invention, modifications of the above-disclosed apparatus and method which fall within the scope of the invention will be readily apparent to those having ordinary skill in the art. For instance, although the inventive brush cores are made of polyvinylidenefluoride material, they may comprise other materials. In addition, the cylindrical shape of the outer diameter of the brush cores may be modified to contour to the profile of the inner diameters of the brushes, which may include the tapered profile detailed in the aforementioned co-pending application. In addition, it is contemplated that the outer core component may be implemented as a plurality of outer core pieces, which may be disposed within the hollow center of the brush and fixed into place by insertion of the inner core component. Finally, it will be understood by those of ordinary skill in the art, that various mechanisms for securing the inner core to the outer core are merely exemplary of the presently preferred embodiment of the invention. The inner and outer core components can be designed with tolerancing and/or surface roughness sufficient to prevent relative movement or slipping between the inner and outer core components, and the invention need not include further securing mechanisms. Further, the notches and slits described herein may assume various shapes and need not extend through the entire thickness of the outer core material. Any brush core whose outer diameter can be compressed is considered to be within the scope of the present invention .

Accordingly, while the present invention has been disclosed in connection with the preferred embodiments thereof, it should be understood that other embodiments may fall within the spirit and scope of the invention, as defined by the following claims.

## Claims

1. A compressible brush core, comprising an elongate member having first means for allowing compression of the outer diameter of the member and further means for selectively prohibiting compression of the outer diameter of the member.

2. A compressible brush core, comprising an outer core component having an outer diameter adapted to fit snugly within a scrubber brush and having at least one notch for allowing compression of the outer diameter, and an inner core component for insertion into the outer core to prevent compression of the outer diameter.

3. A brush core as claimed in Claim 2, wherein the inner core component is adapted to fit snugly into'the outer core component.

4. A brush core as claimed in Claim 2 or claim 3, wherein the at least one notch comprises at least one elongate slit.

5. A brush core as claimed in Claim 4, wherein the at least one elongate slit comprises four slits disposed at 90° angles from each other.

6. A brush core as claimed in any of Claims 2 to 5, further comprising at least one securing means for securing the inner core component and the outer core component to each other.

7. A brush core as claimed in Claim 6, wherein the outer core includes a plurality of rows of threads at the periphery of one end and wherein the at least one securing means comprises a nut for engaging the plurality of rows of threads.

8. A brush core as claimed in any of Claims 2 to 6, wherein the outer core includes a plurality of rows of threads disposed along the inner diameter of one end and wherein the inner core includes a mechanism for engaging the plurality of rows of threads.

9. A brush core as claimed in any of Claims 2 to 8, further comprising hardware for mounting the brush and brush core in a wafer scrubbing mechanism.

10. A brush core as claimed in Claim 9, wherein the hardware for mounting the brush and brush core in a wafer scrubbing mechanism comprises at least one spring-loaded spindle for insertion into the wafer scrubbing mechanism.

11. A scrubber brush assembly comprising:
an outer core component having an outer diameter adapted to fit snugly within a scrubber brush and having at least one notch for allowing selective compression of the outer diameter;
an inner core component for insertion into the outer core to prevent compression of the outer diameter; and
a scrubber brush mounted on the outer core component.

12. An assembly as claimed in Claim 11, further comprising hardware for mounting the assembly in a wafer scrubbing mechanism.

13. An assembly as claimed in Claim 12, wherein the hardware for mounting the brush and brush core in a wafer scrubbing mechanism comprises at least one spring-loaded spindle for insertion into the wafer scrubbing mechanism.

14. A method for loading a hollow centered brush onto a brush core comprising the steps of compressing the brush core, and sliding the compressed brush core into the hollow center of the brush.

15. A method as claimed in Claim 14, in which the brush core comprises a hollow-centered brush core, wherein the method further comprises inserting a rigid inner core into the hollow-centered brush core.

16. A method as claimed in Claim 14, in which the brush core includes at least one notch, wherein the method further comprises selectively compressing the brush core comprises compressing the outer diameter of the brush core along the at least one notch.

17. A method as claimed in Claim 16 wherein the brush core comprises a hollow-centered brush core and wherein the method further comprises inserting a rigid inner core into the hollow-centered brush core.

18. A scrubber brush mounting apparatus comprising:
a pair of opposed spindles adapted to support a scrubber brush; and
a compressible mechanism coupled to one of the spindles so as to allow the spindle to be compressed.

19. An apparatus as claimed in claim 18, wherein the compressible mechanism comprises a spring.

20. An apparatus as claimed in Claim 18, wherein the spindle includes a press plate.
